# EUROPÄISCHE PATENTSCHRIFT

(11) **EP 0 910 128 B1**
(45) Veröffentlichungstag und Bekanntmachung des Hinweises auf die Patenterteilung: **18.03.2009**
(21) Anmeldenummer: 98118694.3
(22) Anmeldetag: 02.10.1998
(51) Int. Cl.: H01L 51/56, G03F 7/09

(54) **Herstellung von organischen elektrolumineszierenden Bauteilen**
Fabrication process for organic electroluminescent devices
Fabrication d'éléments électroluminescents organiques

(30) Priorität: 15.10.1997 DE 19745610
(43) Veröffentlichungstag der Anmeldung: 21.04.1999
(73) Patentinhaber: OSRAM Opto Semiconductors GmbH, 93055 Regensburg (DE)
(72) Erfinder: Herbst, Waltraud, 91080 Uttenreuth (DE); Günther, Ewald, Dr., 91074 Herzogenaurach (DE); Leuschner, Rainer, Dr., 91091 Grossenseebach (DE); Simmerer, Jürgen, Dr., 91056 Erlangen (DE)
(74) Vertreter: Epping - Hermann - Fischer

(56) Entgegenhaltungen:
- EP-A- 0 341 843
- EP-A- 0 732 868
- DE-A- 4 401 590
- US-A- 5 360 698
- TIAN P.F. ET AL: 'Photolithographic patterning of vacuum-deposited organic light emitting devices' APPLIED PHYSICS LETTERS, AIP, AMERICAN INSTITUTE OF PHYSICS, MELVILLE, NY, US Bd. 71, Nr. 22, 01 Dezember 1997, Seiten 3197 - 3199, XP012019166
- HOSOKAWA C. ET AL: 'L2.3: ORGANIC MULTICOLOR EL DISPLAY WITH FINE PIXELS' 1997 SID INTERNATIONAL SYMPOSIUM DIGEST OF TECHNICAL PAPERS. BOSTON, MAY 13 - 15, 1997, SID INTERNATIONAL SYMPOSIUM DIGEST OF TECHNICAL PAPERS, SANTA ANA, SID, US Bd. 28, 13 Mai 1997, Seiten 1073 - 1076, XP000722863

## Beschreibung

Die Erfindung betrifft ein Verfahren zur Herstellung organischer elektrolumineszierender Bauteile mit einer strukturierten Elektrode, insbesondere Displays mit einer strukturierten Metallelektrode.

Mit dem zunehmenden Austausch von Daten und Information gewinnt deren Visualisierung, vorzugsweise in Endgeräten der Kommunikationstechnik, immer mehr an Bedeutung. Diese Informationsdarstellung findet üblicherweise mittels Pixel-Matrix-Anzeigevorrichtungen statt, die gegebenenfalls zusätzliche, fest vorgegebene Symboldarstellungen ("Icons") aufweisen. Bekannte Technologien von Pixel-Matrix-Vorrichtungen sind beispielsweise Kathodenstrahlbildröhren, die allerdings wegen des Platzbedarfs, der elektrischen Leistungsaufnahme und des Gewichts nicht für den Einsatz in mobilen und tragbaren elektronischen Geräten in Frage kommen. Wesentlich besser geeignet sind für diesen Zweck Flachbildschirme ("Flat Panel Displays"), die heutzutage vorwiegend auf der Technologie der Flüssigkristall-Displays (LC-Displays) basieren.

Einfache, monochrome, passiv-matrix-getriebene LC-Displays bieten den Vorteil einer kostengünstigen Herstellbarkeit neben geringer elektrischer Leistungsaufnahme, kleinem Gewicht und geringem Platzbedarf. Jedoch sind mit dem Einsatz derartiger Displays auch gravierende Nachteile verbunden. Aufgrund des technologisch-physikalischen Prinzips sind die Anzeigen nämlich nicht selbst-emittierend, d.h. sie sind nur unter besonders günstigen Umgebungslichtverhältnissen zuverlässig abzulesen und zu erkennen. Eine weitere wesentliche Beschränkung besteht in dem stark eingeschränkten Betrachtungswinkel der Anzeige.

Das Problem des mangelnden Kontrastes bei nicht optimalen Umgebungslichtverhältnissen läßt sich zwar durch eine zusätzlich angebrachte Hinterleuchtung verbessern, allerdings ist diese Verbesserung mit mehreren Nachteilen verbunden. So wird durch die Hinterleuchtung die Dicke des LC-Flachbildschirms vervielfacht. Während nämlich LC-Displays ohne Hinterleuchtung mit einer Dicke < 1 mm gefertigt werden können, beträgt die Gesamtdicke von hinterleuchteten LC-Displays typischerweise einige Millimeter. Neben den Lampen bzw. Leuchtstoffröhren trägt vor allem die zur homogenen Ausleuchtung der Displayfläche notwendige Lichtleitplastik ("Diffusor") zur Vergrößerung der Dicke bei. Ein wesentlicher Nachteil der Hinterleuchtung besteht außerdem darin, daß der überwiegende Anteil der elektrischen Leistungsaufnahme für die Beleuchtung benötigt wird. Darüber hinaus wird zum Betrieb der Lichtquellen (Lampen und Leuchtstoffröhren) eine höhere Spannung benötigt, die üblicherweise mit Hilfe von "Voltage-up-Convertern" aus Batterien oder Akkumulatoren erzeugt wird.

Eine bessere Performance als mit im Passiv-Modus angesteuerten LC-Displays kann mit Aktiv-Matrix-LC-Displays erreicht werden. Dabei ist jedem Bildpunkt mit seinen drei Grundfarben jeweils ein Dünnfilmtransistor (Thin Film Transistor, TFT) zugeordnet. Die TFT-Technologie ist jedoch sehr aufwendig, und aufgrund der hohen auftretenden Prozeßtemperaturen werden hohe Anforderungen an die verwendeten Substrate gestellt; dementsprechend hoch ist der Preis für Aktiv-Matrix-LC-Displays.

Die Schaltzeit eines einzelnen Flüssigkristall-Pixels beträgt - bedingt durch das physikalische Prinzip der Re-Orientierung eines Moleküls im elektrischen Feld - typischerweise einige Millisekunden und ist zudem noch stark temperaturabhängig. So macht sich bei tiefen Temperaturen der langsame und verzögerte Bildaufbau, beispielsweise in Verkehrsmitteln (Navigationssysteme in Kraftfahrzeugen), störend bemerkbar. Für Applikationen, in denen rasch wechselnde Informationen bzw. Bilder zur Anzeige kommen, beispielsweise bei Videoapplikationen, ist die LC-Technologie deshalb nur bedingt einsetzbar.

Andere Display-Technologien haben entweder noch nicht den Reifegrad einer technischen Anwendbarkeit erreicht, beispielsweise Flat-Panel-CRTs (CRT = Cathode Ray Tube), oder ihrem Einsatz, vor allem in tragbaren elektronischen Geräten, stehen gravierende Nachteile aufgrund spezifischer Kenngrößen gegenüber: hohe Betriebsspannung bei Vakuum-Fluoreszenz-Anzeigen und anorganischen Dünnfilm-Elektrolumineszenz-Anzeigen bzw. hohe Kosten bei Displays auf der Basis anorganischer Leuchtdioden.

Die genannten Nachteile lassen sich mit Anzeigen auf der Basis von organischen Leuchtdioden (Organic Light Emitting Diodes, OLEDs) umgehen. Diese neue Technologie weist gegenüber LC-Displays vielfältige Vorteile auf, von denen die wesentlichen folgende sind:
- Aufgrund des Prinzips der Selbstemissivität entfällt die Notwendigkeit einer Hinterleuchtung, was Platzbedarf, Leistungsaufnahme und Gewicht deutlich reduziert.
- Die typischen Schaltzeiten von Bildelementen liegen in der Größenordnung von 1 µs und erlauben damit problemlos die Darstellung schneller Bildfolgen.
- Die Schaltzeiten weisen keine störende Trägheit bei niedrigen Temperaturen auf.
- Der Ablesewinkel ist wesentlich größer als bei LC-Displays und beträgt nahezu 180°.
- Die bei LC-Displays notwendigen Polarisatoren entfallen, so daß eine größere Helligkeit auch bei gemultiplexter Anzeige erreichbar ist.
- Organische Leuchtdioden lassen sich im Gegensatz zu anderen Display-Technologien auch auf flexiblen Substraten und in nicht-planaren Geometrien herstellen.

Die Herstellung und der Aufbau von Displays auf der Basis organischer Leuchtdioden ist im Vergleich zu LC-Displays einfacher und damit kostengünstiger realisierbar. Typischerweise erfolgen Aufbau und Herstellung folgendermaßen.

Das Substrat, beispielsweise Glas, ist ganzflächig mit einer transparenten Elektrode, beispielsweise aus Indium-Zinn-Oxid (ITO), beschichtet. Zur Herstellung von Pixel-Matrix-Anzeigen muß sowohl die transparente Elektrode als auch die Topelektrode strukturiert werden. Beide Elektroden sind dabei üblicherweise in Form von parallelen Leiterbahnen strukturiert, wobei die Leiterbahnen von transparenter Elektrode und Topelektrode senkrecht zueinander verlaufen. Die Strukturierung der transparenten Elektrode erfolgt mit einem photolithographischen Prozeß unter Einschluß naßchemischer Ätzverfahren, deren Details dem Fachmann bekannt sind. Die Auflösung, die mit diesen Verfahren erreichbar ist, wird im wesentlichen durch die photolithographischen Schritte und die Beschaffenheit der transparenten Elektrode begrenzt. Nach dem Stand der Technik sind dabei sowohl Pixelgrößen wie auch nicht emittierende Zwischenräume zwischen den Pixeln von wenigen Mikrometern Größe realisierbar. Die Länge der streifenförmigen Leiterbahnen der transparenten Elektrode kann bis zu vielen Zentimetern betragen. Je nach verwendeter Lithographiemaske können auch emittierende Flächen bis zu einer Größe von mehreren Quadratzentimetern erzeugt werden. Die Abfolge der einzelnen emittierenden Flächen kann regelmäßig (Pixel-Matrix-Display) oder variabel sein (Symboldarstellungen).

Auf das Substrat mit der strukturierten transparenten Elektrode werden eine oder mehrere organische Schichten aufgebracht. Diese organischen Schichten können aus Polymeren, Oligomeren, niedermolekularen Verbindungen oder Mischungen hiervon bestehen. Zum Aufbringen von Polymeren, beispielsweise Polyanilin, Poly(p-phenylen-vinylen) und Poly(2-methoxy-5-(2'-ethyl)-hexyloxy-p-phenylen-vinylen), finden üblicherweise Prozesse aus flüssiger Phase Anwendung (Auftragen einer Lösung mittels Spin-Coating oder Rakeln), während für niedermolekulare und oligomere Verbindungen eine Gasphasenabscheidung bevorzugt wird (Aufdampfen oder "Physical Vapor Deposition", PVD). Beispiele für niedermolekulare, bevorzugt positive Ladungsträger transportierende Verbindungen sind: N,N'-Bis-(3-methylphenyl)-N,N'-bis-(phenyl)-benzidin (m-TPD), 4,4',4''-Tris-(N-3-methylphenyl-N-phenyl-amino)-triphenylamin (m-MTDATA) und 4,4',4''-Tris-(carbazol-9-yl)-triphenylamin (TCTA). Als Emitter wird beispielsweise Hydroxychinolin-Aluminium-III-Salz (Alq) verwendet, das mit geeigneten Chromophoren dotiert sein kann (Chinacridon-Derivate, aromatische Kohlenwasserstoffe u.s.w.). Gegebenenfalls können zusätzliche, die elektrooptischen Eigenschaften ebenso wie die Langzeiteigenschaften beeinflussende Schichten vorhanden sein, beispielsweise aus Kupfer-Phthalocyanin. Die gesamte Dicke der Schichtabfolge kann zwischen 10 nm und 10 µm betragen, typischerweise liegt sie im Bereich zwischen 50 und 200 nm.

Die Topelektrode besteht üblicherweise aus einem Metall, das im allgemeinen durch Gasphasenabscheidung aufgebracht wird (thermisches Verdampfen, Sputtern oder Elektronenstrahlverdampfung). Bevorzugt werden unedle und damit insbesondere gegenüber Wasser und Sauerstoff reaktive Metalle eingesetzt, wie Lithium, Magnesium, Aluminium und Calcium sowie Legierungen dieser Metalle untereinander oder mit anderen Metallen. Die zur Herstellung einer Pixel-Matrix-Anordnung erforderliche Strukturierung der Metallelektrode wird im allgemeinen dadurch erreicht, daß das Metall durch eine Schattenmaske hindurch aufgebracht wird, die entsprechend geformte Öffnungen aufweist.

Ein in dieser Weise hergestelltes OLED-Display kann zusätzliche, die elektrooptischen Eigenschaften beeinflussende Einrichtungen enthalten, wie UV-Filter, Polarisationsfilter, Anti-Reflex-Beschichtungen, als "Micro-Cavities" bekannte Einrichtungen sowie Farbkonversions- und Farbkorrekturfilter. Ferner ist eine hermetische Verpackung ("Packaging") vorhanden, durch das die organischen elektrolumineszierenden Displays vor Umwelteinflüssen, wie Feuchtigkeit und mechanische Belastungen, geschützt werden. Außerdem können Dünnfilmtransistoren zur Ansteuerung der einzelnen Bildelemente ("Pixel") vorhanden sein.

Für hochauflösende Displays, mit denen die Darstellung eines großen Informationsgehaltes möglich ist, ist eine feine Strukturierung der Metallelektrode in Form von Leiterbahnen erforderlich, d.h. sowohl die Breite der Leiterbahnen als auch die Zwischenräume müssen unter Einhaltung enger Toleranzen im µm-Bereich strukturierbar sein. Die Breite einer Leiterbahn kann dabei zwischen 10 µm und mehreren hundert Mikrometern liegen, bevorzugt zwischen 100 und 300 µm. Zum Erreichen eines hohen Füllfaktors (Anteil der aktiven, Licht emittierenden Fläche im Verhältnis zur Gesamtfläche der Display-Anordnung) ist es außerdem erforderlich, daß die Zwischenräume zwischen den metallischen Leiterbahnen wie auch die Zwischenräume zwischen den Leiterbahnen der transparenten Elektrode nur wenige Mikrometer betragen.

Zur Herstellung strukturierter Metallelektroden kann zunächst durch einen Gasphasenprozeß ganzflächig eine Metallschicht aufgebracht werden, die nachfolgend mit photolithographischen Methoden strukturiert wird. Dies hat aber den entscheidenden Nachteil, daß beim Entfernen der nicht benötigten Teile der Metallschicht ("Zwischenräume") die empfindlichen organischen Funktionsschichten beschädigt werden können. Derartige Prozesse zum definierten Entfernen von Teilen der Metallschicht sind beispielsweise "Lift-Off-Prozesse" und Plasmaätzen. Da jedoch bereits die Beschädigung bzw. Zerstörung einzelner Bildelemente zu einer erheblichen Beeinträchtigung bis hin zur Unbrauchbarkeit des gesamten Displays führt, ist mit den genannten Techniken eine sichere Prozeßführung und damit eine hohe Ausbeute in der Produktion nicht realisierbar. Erschwerend kommt hinzu, daß der Einsatz sowohl von wäßrigen als auch von organischen Lösemitteln zum Entfernen eines Teiles der Metallschicht - durch störende Diffusion der Lösemittel in die organischen Funktionsschichten - nur äußerst begrenzt möglich ist.

Eine weitere Möglichkeit zur Strukturierung der Metallelektrode besteht in der selektiven Abscheidung des Metalls, beispielsweise in Form von Leiterbahnen, durch entsprechend strukturierte Schattenmasken. Diese Schattenmasken können aus Edelstahl oder aus photolithographisch strukturierbarem Glas hergestellt sein. Die Zwischenräume zwischen einzelnen Leiterbahnen entsprechen dabei auf der Seite der Schattenmaske dünnen "Stegen", die eigentlichen Leiterbahnen der Metallelektrode werden durch entsprechend geformte Öffnungen hindurch abgeschieden. Sowohl aus Gründen der Stabilität der Schattenmaske als auch aus produktionstechnischen Gründen bei deren Fertigung sind Stegbreiten < 150 µm bei Edelstahl bzw. < 90 µm bei Glas nicht zuverlässig herstellbar. Erschwerend kommt hinzu, daß während des Abscheideprozesses des Metalls der Abstand zwischen Substrat und Maske nur wenige Mikrometer betragen darf, um scharfe Kanten der metallischen Strukturen zu gewährleisten. Die Schattenmaske darf außerdem nicht durch zu großen Anpreßdruck auf das Substrat die organischen Funktionsschichten beschädigen. Darüber hinaus wird die Herstellung von nicht-planaren organischen Leuchtdioden auf gekrümmten Flächen durch die genannten Probleme substantiell erschwert. Ein weiteres Problem in bezug auf die Fertigungstauglichkeit von organischen LED-Displays mit Schattenmasken besteht darin, daß das Substrat mit den organischen Funktionsschichten reproduzierbar mit hohem Durchsatz (Produktion einiger tausend Displays pro Tag) bis auf wenige Mikrometer genau über den zugehörigen Strukturen der Schattenmaske positioniert werden muß. Ferner können mit Schattenmasken - aus geometrischen Gründen - keine Formen oder Symbole dargestellt werden, bei denen eine nicht-emittierende Fläche vollständig von einer emittierenden Fläche umschlossen ist, beispielsweise konzentrische Kreise.

Aus der US-Patentschrift 5 276 380 sind elektrolumineszierende Displays bekannt, bei denen zwischen den Licht emittierenden Pixelreihen senkrecht stehende "Wände" angeordnet sind, die das organische elektrolumineszierende Medium überragen. Ein derartiger Aufbau hat den Nachteil, daß er nicht zur Herstellung beliebig geformter Symbole geeignet ist. Außerdem ist die Größe der einzelnen Bildelemente durch die Höhe der Wände begrenzt. Großflächige Anzeigen lassen sich auf diese Weise somit nicht realisieren.

Die Druckschrift EP 0 732 868 A1 offenbart ein Verfahren zur Herstellung einer elektrolumineszierenden Anzeigevorrichtung mit elektrisch isolierenden Wällen, die einen Überhang aufweisen.

Die Druckschrift DE 44 01 590 A1 beschreibt ein Verfahren zur Herstellung strukturierte Metallisierungen unter Verwendung einer ersten Photolackschicht, deren Oberfläche in Benzol getränkt wird, und einer zweiten Photolackschicht.

Die Druckschrift US 5,360,698 offenbart ein lithographisches Strukturierungsverfahren, das zwei Schichten benutzt. Die untere Schicht ist mit Licht im fernen Ultraviolett strukturierbar. Die obere Schicht ist mit einer von fernem Ultraviolett verschiedenen Wellenlänge strukturierbar, hat im fernen Ultraviolett eine geringe optische Transmission und vernetzt bei Bestrahlung mit Licht im fernen Ultraviolett-Bereich.

Aufgabe der Erfindung ist es, ein Verfahren anzugeben, das die fertigungstaugliche Herstellung von strukturierten Elektroden in organischen elektrolumineszierenden Bauteilen erlaubt, und zwar insbesondere von feinstrukturierten metallischen Top-Elektroden für hochauflösende Displays bzw. für Darstellungen, die feinstrukturierte Details enthalten, wobei eine gleichzeitige Darstellung von separaten Symbolen und Informationen auf der pixelierten Displayfläche möglich sein soll.

Dies wird erfindungsgemäß durch das Verfahren gemäß Anspruch 1 erreicht. Bei dem Verfahren werden auf eine auf einem Substrat befindliche Bottom-Elektrode mindestens zwei Schichten aufgebracht, wobei die erste Schicht elektrisch isolierend ist und beim Aufbringen der zweiten Schicht nicht geschädigt wird und zwischen den beiden Schichten eine definierte Grenze erhalten bleibt, und wobei die erste Schicht eine höhere Löslichkeitsrate in einem flüssigen Entwickler aufweist als die zweite Schicht und die zweite Schicht strukturierbar ist. Die zweite Schicht wird strukturiert und die Struktur in die erste Schicht übertragen. Auf die zweite Schicht wird wenigstens eine organische Funktionsschicht aufgebracht wird und auf der organischen Funktionsschicht wird eine Top-Elektrode abgeschieden.

Durch die Erfindung wird ein neuartiges Verfahren zur Herstellung organischer elektrolumineszierender Bauteile geschaffen. Dieses Verfahren ermöglicht die Herstellung von strukturierten Elektroden, wie Metallelektroden, insbesondere für organische elektrolumineszierende Displays, ohne daß die Gefahr einer Beschädigung der organischen Funktionsschichten besteht, wie dies bei bekannten Prozessen der Fall ist. Außerdem kann auf die Verwendung von fehleranfälligen Schattenmasken verzichtet werden, und die erreichbare Auflösung wird hinsichtlich Untergrenze und Bandbreite deutlich vergrößert.

Die Top-Elektrode, die vorzugsweise eine kleine Austrittsarbeit für Elektronen aufweist und damit als elektroneninjizierende Elektrode fungiert, besteht insbesondere aus Metall oder einer metallischen Legierung. Diese Elektrode kann jedoch auch einen Schichtaufbau aufweisen, wobei auf einer dünnen dielektrischen Schicht (< 5 nm), die beispielsweise aus Lithiumfluorid oder Aluminiumoxid besteht, eine Metall- oder ITO-Schicht als (transparente) Elektrode angeordnet ist.

Beim Verfahren nach der Erfindung ist wesentlich, daß die erste auf die Bottom-Elektrode, die strukturiert sein kann, aufgebrachte Schicht, d.h. die untere Schicht, beim Aufbringen der zweiten Schicht (obere Schicht) nicht geschädigt wird und zwischen den beiden Schichten eine definierte Grenze erhalten bleibt. Die erste und die zweite Schicht besteht aus einem Photolack.

Photolacke, die auch als Photoresists bezeichnet werden, sind lichtempfindliche, filmbildende Materialien, deren Löslichkeitsverhalten sich durch Belichtung oder durch Bestrahlung ändert; dabei wird zwischen positiven und negativen Photolacken unterschieden. Besteht wie im vorliegenden Fall sowohl die obere als auch die untere Schicht aus einem Photolack und sind beide Photolacke im gleichen Wellenlängenbereich empfindlich, dann darf der Photolack der unteren Schicht kein negativ arbeitendes System sein.

Das Verfahren nach der Erfindung beinhaltet als wesentliches Merkmal einen photolithographischen Prozeß. Bei einer bevorzugten Ausführungsform werden auf die transparente Bottom-Elektrode, gegebenenfalls nach deren Strukturierung, wenigstens zwei Schichten aufgebracht, von denen die erste Schicht aus einem positiven Photolack und die zweite Schicht aus einem positiven oder negativen Photolack besteht; die erste Schicht aus Photolack wird vor dem Aufbringen der zweiten Schicht flutbelichtet. Die Schichten werden dann derart strukturiert, daß die organischen Funktionsschichten und die (metallische) Top-Elektrode darauf flächig aufgebracht bzw. abgeschieden werden können. Die Strukturierung der Schichten bzw. der Top-Elektrode verläuft dabei quer zur Strukturierung der Bottom-Elektrode. Das Aufbringen der organischen Funktionsschicht(en) auf die zweite Schicht kann allgemein sowohl durch einen thermischen Verdampfungsprozeß als auch aus einer Lösung, beispielsweise durch Aufschleudern oder Rakeln und anschließende Trocknung, erfolgen.

Beim photolithographischen Verfahrensschritt ist folgendes wichtig. Die erste der beiden Schichten muß überlackfähig ("overcoatable") sein. Dies bedeutet, daß die beiden Schichten ohne ein sogenanntes Intermixing übereinander aufgebracht werden können, d.h. die eingesetzten Lacke sind in unterschiedlichen Lösemitteln löslich, so daß der (Photo)Lack der ersten Schicht durch das Lösemittel für den Photolack der zweiten Schicht nicht angegriffen wird. Dadurch ist gewährleistet, daß der definierte Aufbau der ersten Schicht beim Aufbringen der zweiten Schicht erhalten bleibt und zwischen den beiden Schichten eine definierte Grenze existiert.

Für den photolithographischen Verfahrensschritt ist außerdem erforderlich, daß die erste Schicht eine höhere Entwicklungsrate aufweist als die zweite Schicht. Dies bedeutet, daß bei der - nach der Belichtung - für die Strukturierung erforderlichen Behandlung der Lackschichten mit einer Entwicklerlösung sich die erste Schicht schneller auflöst als die zweite Schicht. Von Vorteil ist es dabei, wenn die beiden Schichten mit demselben Entwickler, der insbesondere ein wäßrig-alkalischer Entwickler ist, behandelt, d.h. entwickelt werden können.

Für die untere Schicht werden im allgemeinen elektrisch isolierende organische oder anorganische Materialien verwendet. Geeignete anorganische Materialien sind beispielsweise Siliciumdioxid, Siliciumnitrid und Aluminiumoxid.

Die untere Schicht ist photosensitiv und besteht dabei vorzugsweise aus einem positiven Photoresist auf der Basis von Polyglutarimid oder Polybenzoxazol.

Die obere Schicht ist vorteilhaft ebenfalls ein Photolack. Vorzugsweise besteht diese Schicht aus einem positiven Photoresist (Positivresist) auf Novolak/Diazochinon-Basis oder aus einem negativen Photoresist (Negativresist) auf der Basis Novolak/Vernetzer/Photosäure. Als Positivresist können auch Poly(methylmethacrylat) (PMMA), Poly(methylisopropylketon) (PMIPK) und sogenannte chemisch verstärkte Systeme auf Poly(p-hydroxystyrol)-Basis mit tert.-Butoxycarbonyl-Schutzgruppen (t-BOC-Gruppen) eingesetzt werden. Als Negativresist können beispielsweise auch vernetzbare Poly(silphenylensiloxane) dienen.

Die obere Schicht weist nach der Strukturierung vorteilhaft eine größere Strukturbreite auf als die untere Schicht. Der Unterschied in der Strukturbreite ("Überhang") beträgt dabei vorteilhaft zwischen 0,1 und 50 pm, insbesondere zwischen 1 und 10 µm. Vorzugsweise beträgt die Dicke der unteren Schicht 0,1 bis 30 µm, insbesondere 0,5 bis 10 µm, und diejenige der oberen Schicht 0,1 bis 30 pm, insbesondere 0,5 bis 5 µm.

Ein wesentlicher Vorteil des Verfahrens nach der Erfindung besteht darin, daß es sowohl für Pixel-Displays als auch für beliebig geformte Symbole ("Icons") anwendbar ist. Eine elektrolumineszierende Anzeige beispielsweise kann somit aus einem zentralen Bereich mit einzelnen, in Zeilen und Spalten angeordneten Bildelementen (Pixeln) bestehen, die von einer Reihe von Symbolen umgeben sind. Weitere Vorteile bestehen in folgendem:
- Auf die Verwendung von Schattenmasken zur strukturierenden Abscheidung der (metallischen) Top-Elektrode kann verzichtet werden. Damit entfällt ein kostenintensiver und fehleranfälliger Prozeßschritt.
- Die zur Entfernung eines Teiles der Metallelektrode notwendigen Prozesse entfallen. Damit besteht keine Gefahr, daß die organischen Funktionsschichten durch Plasmaprozesse oder durch die Einwirkung von Lösemitteln geschädigt werden. Außerdem wird ein hohes Maß an Prozeßsicherheit und -stabilität erreicht, durch die Erhöhung der Ausbeute sind günstigere Kosten zu realisieren.
- Die Metallelektrode kann großflächig abgeschieden werden. Die auf den Zwischenräumen zwischen den eigentlichen Leiterbahnen abgeschiedenen Teile brauchen nicht entfernt zu werden, da zwischen den eigentlichen Leiterbahnen und dem Metall in den Zwischenräumen keine elektrisch leitende Verbindung besteht.
- Gegenüber der Strukturierung der Metallelektrode mittels einer einzigen Photolackschicht besteht der wesentliche Vorteil, daß die erreichbare "Unterschneidung" bei einer Zweischichtanordnung deutlich größer ist als bei einer Anordnung mit nur einer Schicht. Die Wahrscheinlichkeit für einen elektrischen Kurzschluß zwischen zwei benachbarten metallischen Leiterbahnen, der zum Versagen eines Displays führen würde, ist somit wesentlich geringer.

Anhand von Ausführungsbeispielen und einer Figur soll die Erfindung noch näher erläutert werden.

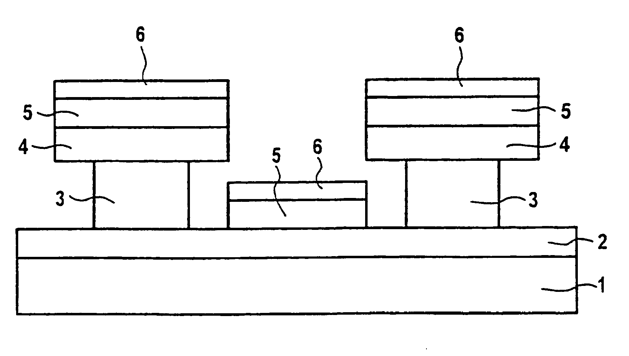

Die Figur zeigt - nicht maßstäblich - einen schematischen Querschnitt durch eine nach dem erfindungsgemäßen Verfahren hergestellte organische Leuchtdiode. Dabei befindet sich auf einem Substrat 1 eine transparente strukturierte Bottom-Elektrode 2. Das Substrat, das eine nicht-planare Geometrie aufweisen kann, besteht beispielsweise aus Glas, Metall, wie Silicium, oder aus einem Polymer (in Form einer Folie); die Bottom-Elektrode ist beispielsweise eine ITO-Elektrode (ITO = Indium Tin Oxide). Die nachfolgenden Schichten sind eine untere Photolackschicht 3, eine obere Photolackschicht 4 und eine organische Funktionsschicht 5. Auf der organischen Funktionsschicht 5 befindet sich dann die strukturierte Top-Elektrode 6 (Metallelektrode).

Bei der Herstellung der in der Figur schematisch dargestellten Anordnung können die Materialien für die organischen Funktionsschichten aus mehreren Verdampferquellen, die in geeignetem Abstand zueinander angeordnet sind, gleichzeitig aufgedampft werden; anschließend wird dann die Metallelektrode aufgebracht. Außerdem kann der Abstand zwischen Verdampferquelle und Substrat während der Deposition der organischen Funktionsschichten anders sein als der Abstand zwischen Verdampferquelle und Substrat während der Deposition der Metallelektrode. Ferner kann das Substrat während der Deposition der organischen Funktionsschichten bewegt werden, während es bei der Deposition der Metallelektrode in seiner Position gehalten wird.

### Beispiel 1

Herstellung eines OLED-Displays mit einer photosensitiven ersten Schicht

Die Herstellung des Displays verläuft nach folgenden Prozeßschritten:
1. Eine ganzflächig mit Indium-Zinn-Oxid (ITO) beschichtete Glasplatte wird mit Hilfe eines photolithographischen Verfahrens mit anschließendem naßchemischen Ätzen derart strukturiert, daß parallele Leiterbahnen mit einer Breite von ca. 200 µm und einem Zwischenraum von ca. 50 µm entstehen. Die Leiterbahnen sind jeweils etwa 2 cm lang und enthalten an ihrem äußeren Ende gegebenenfalls Zusätze zur Kontaktierung. Der bei der Strukturierung verwendete Photolack wird vollständig entfernt.
2. Die Glasplatte wird ca. 1 h bei einer Temperatur von 250°C ausgeheizt, dann wird ein kommerzieller Photolack auf der Basis von Polyglutarimid aufgeschleudert (Aufbringen während 10 s bei 700 U/min, Abschleudern für 30 s bei 4000 U/min). Die erhaltene Schicht wird 170 s bei 250°C auf einer Heizplatte getrocknet. Anschließend erfolgt eine Flutbelichtung bei einer Wellenlänge von 248 nm (polychromatisch) mit einer Dosis von 1000 mJ/cm². Danach wird ein kommerzieller Photolack auf der Basis von Novolak/Diazochinon (10:1 mit (1-Methoxy-2-propyl)-acetat verdünnt) bei 2000 U/min während 20 s aufgeschleudert. Die beiden Schichten werden 60 s bei 100°C getrocknet, und anschließend wird mit einer Dosis von 62 mJ/cm² bei einer Wellenlänge von 365 nm (polychromatisch) durch eine Lithographiemaske belichtet. Dann wird mit einem Tetramethylammoniumhydroxyd enthaltenden kommerziellen Entwickler - je nach dem gewünschten Überstand der oberen Schicht - 40 bis 80 s entwickelt; bei einer Entwicklungszeit von 60 s wird beispielsweise ein Überstand von etwa 10 µm erhalten. Die Schichtdicke der unteren Schicht beträgt etwa 900 nm; beide Schichten zusammen sind etwa 2,6 µm dick. Anschließend werden mittels eines Sauerstoffplasmas (RF-Leistung: 500 W, Gasfluß: 30 sccm) für 20 s Lackreste von der ITO-Oberfläche entfernt.
3. Bei einem Druck von 10⁻⁵ mbar wird durch konventionelles thermisches Aufdampfen eine Schicht aus N,N'-Bis(3-methylphenyl)-N,N'-bis(phenyl)-benzidin (m-TPD) aufgebracht (Schichtdicke: 135 nm, Aufdampfrate: 0,2 nm/s). Ohne Änderung des Druckes, d.h. ohne Belüften des Vakuum-Rezipienten, wird anschließend durch thermisches Verdampfen eine Schicht aus Hydroxychinolin-Aluminium(III)-Salz (Alq) mit einer Dicke von 65 nm aufgebracht (Aufdampfrate: 0,2 nm/s).
4. Ohne Verwendung einer Maske wird durch thermisches Verdampfen Magnesium in einer Schichtdicke von 100 nm auf die aktive Fläche des Displays aufgebracht (Depositionsrate: 1 nm/s, Druck: 10⁻⁵ mbar). Ohne das Vakuum zu unterbrechen, wird - ebenfalls durch thermisches Verdampfen - Silber in einer Schichtdicke von 100 nm auf die aktive Display-Fläche aufgebracht (Depositionsrate: 1 nm/s, Druck: 10⁻⁵ mbar).

Das Display leuchtet deutlich sichtbar auch bei hellem Tageslicht unter Sonneneinstrahlung, die Emissionsfarbe ist grünlich-gelb.

### Beispiel 2

Herstellung von organischen Leuchtdioden gemäß dem Stand der Technik bzw. gemäß der Erfindung

Es werden zwei Proben hergestellt, eine unter Verwendung einer konventionellen Schattenmaske (Probe A), die andere unter Anwendung des erfindungsgemäßen Verfahrens (Probe B).

### Probe A:

Auf einer mit Indium-Zinn-Oxid beschichteten Glasplatte werden in bekannter Weise photolithographisch 2 mm breite ITO-Leiterbahnen erzeugt. Danach wird bei einem Druck von 10⁻⁵ mbar eine 135 nm dicke Schicht aus N,N'-Bis(3-methylphenyl)-N,N'-bis(phenyl)-benzidin (m-TPD) abgeschieden. Ohne das Vakuum zu unterbrechen, wird dann eine 65 nm dicke Schicht aus Hydroxychinolin-Aluminium(III)-Salz (Alq) abgeschieden. Beide Schichten werden dabei durch thermisches Aufdampfen ("Physial Vapor Deposition", PVD) erzeugt (Depositionsrate: jeweils 0,2 nm/s). Durch eine Schattenmaske wird dann eine 100 nm dicke Magnesiumschicht und anschließend eine 100 nm dicke Silberschicht in der Weise abgeschieden, daß 2 mm breite metallische Leiterbahnen entstehen (Druck: 10⁻⁵ mbar, Depositionsrate: 1 nm/s). Die metallischen Leiterbahnen verlaufen senkrecht zu den Leiterbahnen aus Indium-Zinn-Oxid, so daß durch die Anordnung die aktive, emittierende Fläche der organischen LED 2 x 2 mm² beträgt.

### Probe B:

Auf einer mit Indium-Zinn-Oxid beschichteten Glasplatte werden in bekannter Weise photolithographisch 2 mm breite ITO-Leiterbahnen erzeugt. Die Glasplatte wird ca. 1 h bei einer Temperatur von 250°C ausgeheizt, dann wird ein kommerzieller Photolack auf der Basis von Polyglutarimid aufgeschleudert (Aufbringen während 10 s bei 700 U/min, Abschleudern für 30 s bei 4000 U/min). Die erhaltene Schicht wird 170 s bei 250°C auf einer Heizplatte getrocknet. Anschließend erfolgt eine Flutbelichtung bei einer Wellenlänge von 248 nm (polychromatisch) mit einer Dosis von 1000 mJ/cm². Danach wird ein kommerzieller Photolack auf der Basis von Novolak/Diazochinon (10:1 mit (1-Methoxy-2-propyl)-acetat verdünnt) bei 2000 U/min während 20 s aufgeschleudert. Die beiden Schichten werden 60 s bei 100°C getrocknet, und anschließend wird mit einer Dosis von 62 mJ/cm² bei einer Wellenlänge von 365 nm (polychromatisch) durch eine Lithographiemaske belichtet. Dann wird mit einem Tetramethylammoniumhydroxyd enthaltenden kommerziellen Entwickler - je nach dem gewünschten Überstand der oberen Schicht - 40 bis 80 s entwickelt; bei einer Entwicklungszeit von 60 s wird beispielsweise ein Überstand von etwa 10 µm erhalten. Die Schichtdicke der unteren Schicht beträgt etwa 900 nm; beide Schichten zusammen sind etwa 2,6 µm dick. Anschließend werden mittels eines Sauerstoffplasmas (RF-Leistung: 500 W, Gasfluß: 30 sccm) für 20 s Lackreste von der ITO-Oberfläche entfernt. Danach wird bei einem Druck von 10⁻⁵ mbar eine 135 nm dicke Schicht aus N,N'-Bis(3-methylphenyl)-N,N'-bis(phenyl)-benzidin (m-TPD) abgeschieden. Ohne das Vakuum zu unterbrechen, wird dann eine 65 nm dicke Schicht aus Hydroxychinolin-Aluminium(III)-Salz (Alq) abgeschieden. Beide Schichten werden dabei durch thermisches Aufdampfen ("Physical Vapor Deposition", PVD) erzeugt (Depositionsrate: jeweils 0,2 nm/s). Ohne Verwendung einer Schattenmaske wird dann Magnesium und anschließend Silber flächig abgeschieden (Druck: 10⁻⁵ mbar, Depositionsrate: 1 nm/s, Dicke: jeweils 100 nm). Aufgrund der vorhandenen Anordnung aus zwei strukturierten Photolackschichten entstehen dabei 2 mm breite metallische Leiterbahnen. Die metallischen Leiterbahnen verlaufen senkrecht zu den Leiterbahnen aus Indium-Zinn-Oxid, so daß durch die Anordnung die aktive, emittierende Fläche der organischen LED 2 x 2 mm² beträgt.

Bei einem Vergleich der emittierten Lichtintensität in Abhängigkeit von der erforderlichen Stromdichte von Probe A und Probe B zeigt sich, daß mittels des Verfahrens nach der Erfindung organische Leuchtdioden hergestellt werden können, die gegenüber solchen, die nach dem bekannten Stand der Technik hergestellt werden, keine Nachteile aufweisen. Wie bereits ausgeführt, weisen sie aber erhebliche Vorteile auf.

## Patentansprüche

1. Verfahren zur Herstellung organischer elektrolumineszierender Bauteile mit einer strukturierten Elektrode, insbesondere Displays mit einer strukturierten Metallelektrode, wobei auf eine auf einem Substrat (1) befindliche Bottom-Elektrode (2) mindestens zwei Schichten (3, 4) aufgebracht werden, wobei die erste Schicht und/oder die zweite Schicht aus einem organischen filmbildenden Material besteht, wobei die erste Schicht (3) überlackfähig ist, sodass sie beim Aufbringen der zweiten Schicht (4) nicht geschädigt wird und zwischen den beiden Schichten eine definierte Grenze erhalten bleibt, und elektrisch isolierend ist, **dadurch gekennzeichnet**
- **daß** die erste Schicht eine höhere Löslichkeitsrate in einem flüssigen Entwickler aufweist als die zweite Schicht und die zweite Schicht aus einem positiven oder negativen Photolack besteht,
- **daß** die erste Schicht aus einem positiven Photolack besteht und vor dem Aufbringen der zweiten Schicht flutbelichtet wird,
- **daß** die zweite Schicht strukturiert wird, wobei das Strukturieren der zweiten Schicht einen photolithographischen Prozeß umfasst,
- **daß** die Struktur in die erste Schicht übertragen wird, wobei das Übertragen der Struktur ein Entwickeln der ersten Schicht in dem flüssigen Entwickler umfasst,
- **daß** auf die zweite Schicht wenigstens eine organische Funktionsschicht (5) aufgebracht wird,
- und **daß** auf der organischen Funktionsschicht eine Top-Elektrode (6) abgeschieden wird.

2. Verfahren nach Anspruch 1, **dadurch gekennzeichnet, daß** die erste Schicht (3) aus einem positiven Photolack auf der Basis von Polyglutarimid oder Polybenzoxazol besteht.

3. Verfahren nach einem der Ansprüche 1 oder 2, **dadurch gekennzeichnet, daß** die zweite Schicht (4) aus einem positiven Photolack auf der Basis Novolak/Diazochinon besteht.

4. Verfahren nach einem der Ansprüche1 oder 2, **dadurch gekennzeichnet, daß** die zweite Schicht (4) aus einem negativen Photolack auf der Basis Novolak/Photosäure besteht.

5. Verfahren nach einem der vorhergehenden Ansprüche, **dadurch gekennzeichnet, dass** die organische Funktionsschicht (5) durch einen thermischen Verdampfungsprozess aufgebracht wird.

6. Verfahren nach einem der Ansprüche 1 bis 4, **dadurch gekennzeichnet, dass** die organische Funktionsschicht (5) aus einer Lösung aufgebracht wird.

7. Verfahren nach Anspruch 6, **dadurch gekennzeichnet, dass** die organische Funktionsschicht (5) durch Aufschleudern oder Rakeln aufgebracht wird.

## Claims

1. Method for producing organic electroluminescent components having a structured electrode, in particular displays having a structured metal electrode, wherein at least two layers (3, 4) are applied to a bottom electrode (2) which is located on a substrate (1), wherein the first layer and/or the second layer is composed of an organic film-forming material, wherein the first layer (3) can be coated such that it is not damaged when the second layer (4) is applied and a defined boundary remains between the two layers, and is electrically insulating,
**characterized**
- **in that** the first layer has a higher solubility rate in a liquid developer than the second layer, and the second layer is composed of a positive or negative photoresist,
- **in that** the first layer is composed of a positive photoresist and is floodlit before application of the second layer,
- **in that** the second layer is structured, with the structuring of the second layer comprising a photolithographic process,
- **in that** the structure is transferred to the first layer, with the transfer of the structure comprising the first layer being developed in the liquid developer,
- **in that** at least one organic functional layer (5) is applied to the second layer,
- and **in that** a top electrode (6) is deposited on the organic functional layer.

2. Method according to Claim 1, **characterized in that** the first layer (3) is composed of a positive photoresist based on polyglutarimide or polybenzoxazol.

3. Method according to one of Claims 1 or 2, **characterized in that** the second layer (4) is composed of a positive photoresist based on Novolak/diazoquinone.

4. Method according to one of Claims 1 or 2, **characterized in that** the second layer (4) is composed of a negative photoresist based on Novolak/photo-acid.

5. Method according to one of the preceding claims, **characterized in that** the organic functional layer (5) is applied by means of a thermal vapour-deposition process.

6. Method according to one of Claims 1 to 4, **characterized in that** the organic functional layer (5) is applied from a solution.

7. Method according to Claim 6, **characterized in that** the organic functional layer (5) is applied by centrifuging or wiping.

## Revendications

1. Procédé de fabrication de composants organiques électroluminescents présentant une électrode structurée, et en particulier d'affichages présentant une électrode métallique structurée, dans lequel :
- au moins deux couches (3, 4) sont appliquées sur une électrode de base (2) située sur un substrat (1), la première couche et/ou la deuxième couche étant constituées d'un matériau organique de formation d'un film et la première couche (3) pouvant être recouverte de telle sorte que lorsque la deuxième couche (4) est appliquée, elle n'est pas endommagée et qu'entre les deux couches on obtient une frontière définie, la première couche étant électriquement isolante,
**caractérisé en ce que**
- la première couche a un taux de solubilité dans un développeur liquide plus élevé que la deuxième couche et la deuxième couche est constituée d'un photovernis positif ou négatif,
- la première couche est constituée d'un photovernis positif et est éclairée uniformément avant l'application de la deuxième couche,
- la deuxième couche est structurée, la structuration de la deuxième couche comprenant une opération de photolithographie,
- la structure est transférée à la première couche, le transfert de la structure comprenant le développement de la première couche dans le développeur liquide,
- au moins une couche organique fonctionnelle (5) est appliquée sur la deuxième couche et
- une électrode supérieure (6) est déposée sur la couche organique fonctionnelle.

2. Procédé selon la revendication 1, **caractérisé en ce que** la première couche (3) est constituée d'un photovernis positif à base de polyglutarimide ou de polybenzoxazole.

3. Procédé selon l'une des revendications 1 ou 2, **caractérisé en ce que** la deuxième couche (4) est constituée d'un photovernis positif à base de Novolak/diazoquinone.

4. Procédé selon l'une des revendications 1 ou 2, **caractérisé en ce que** la deuxième couche (4) est constituée d'un photovernis négatif à base de Novolak/photoacide.

5. Procédé selon l'une des revendications précédentes, **caractérisé en ce que** la couche organique fonctionnelle (5) est appliquée par une opération de vaporisation thermique.

6. Procédé selon l'une des revendications 1 à 4, **caractérisé en ce que** la couche organique fonctionnelle (5) est appliquée à partir d'une solution.

7. Procédé selon la revendication 6, **caractérisé en ce que** la couche organique fonctionnelle (5) est appliquée par centrifugation ou au racloir.
